(19) **Europäisches Patentamt / European Patent Office / Office européen des brevets**

(11) **EP 1 901 081 A1**

(12) **EUROPÄISCHE PATENTANMELDUNG**

(43) Veröffentlichungstag:
**19.03.2008 Patentblatt 2008/12**

(51) Int Cl.:
*G01R 31/36* (2006.01)

(21) Anmeldenummer: **07017561.7**

(22) Anmeldetag: **07.09.2007**

(84) Benannte Vertragsstaaten:
**AT BE BG CH CY CZ DE DK EE ES FI FR GB GR HU IE IS IT LI LT LU LV MC MT NL PL PT RO SE SI SK TR**
Benannte Erstreckungsstaaten:
**AL BA HR MK YU**

(30) Priorität: **18.09.2006 DE 102006044354**

(71) Anmelder: **VB Autobatterie GmbH & Co. KGaA**
**30419 Hannover (DE)**

(72) Erfinder:
• **Koch, Ingo**
  **31789 Hameln (DE)**
• **Meißner, Eberhard**
  **31515 Wunstorf (DE)**

(74) Vertreter: **Gerstein, Hans Joachim et al**
**Gramm, Lins & Partner GbR**
**Freundallee 13a**
**30173 Hannover (DE)**

(54) **Einrichtung und Verfahren zur Batteriezustandsermittlung**

(57) Bei einem Verfahren zur Batteriezustandsermittlung erfolgt ein statistisches Bewerten mindestens einer ermittelten Kenngröße (Z) für den Batteriezustand mittels einer statistischen Prozesskontrolle.

$$Qv(n)$$
$$z$$

a)
$$Z2 = \min(z, 100)$$
$$R = abs(Qv(n) - Qv(n-1))$$
$$UCL\_Qv = Xm + 2{,}66 * Rm$$
$$LCL\_Qv = Xm - 2{,}66 * Rm$$
$$UCL\_R = 3{,}267 * Rm$$
$$Xm = 1/z2 * ((z2 - 1) * Xm + Qv(n))$$
$$Rm = 1/(z2 - 1) * ((z2 - 2) * Rm + R)$$

b) $Rm > 5$ ? — Ja

c) Starke Streuung von Qv oder T oder U00 stark fehlerbehaftet => großer Fehler des Wertes Qv(n)

Nein

d) $(Qv(n) > UCL\_Qv \mid Qv < LCL\_Qv) \& (R > UCL\_R)$ — Ja

e) Messwert stark fehlerbehaftet => Qv(n) löschen und nicht verwenden

Nein

f) $(Qv(n) > UCL\_Qv \mid Qv < LCL\_Qv) \& (R \le UCL\_R)$ — Ja

g) Qv verändert sich schnell, Qv(n) ist plausibel => Qv(n-1) = Qv(n)

Nein

h) $(Qv(n) \le UCL\_Qv \mid Qv \ge LCL\_Qv) \& (R > UCL\_R)$ — Ja

i) Messwert stark fehlerbehaftet => Qv(n) löschen und nicht verwenden

Nein

j) $Qv(n-1) = Qv(n)$

Fig. 1

EP 1 901 081 A1

**Beschreibung**

Die Erfindung betrifft ein Verfahren zur Batteriezustandsermittlung sowie eine Einrichtung zur Batteriezustandsermittlung mit einer Messeinheit für die Batterieklemmenspannung und/oder dem Batterieklemmenstrom und mit einer Einheit zur Ermittlung mindestens einer Kenngröße für den Batteriezustand aus der gemessenen Batterieklemmenspannung und/oder dem Batterieklemmenstrom.

Zur Ermittlung des Zustands einer Batterie, insbesondere eines Akkumulators, wie beispielsweise eines Bleiakkumulators, der als Starterbatterie in Kraftfahrzeugen eingesetzt wird, sind vielfältigste Verfahren bekannt und haben sich im praktischen Einsatz bewährt.

Beispielsweise ist in der EP 1 353 190 A1 ein Verfahren zur Bestimmung des Verschleißes einer elektrochemischen Speicherbatterie beschrieben, bei dem eine fortlaufende Ermittlung der umgesetzten Ladungsmengen während der Lagezyklen des Energiespeichers und eine Berechnung einer einen Verlust an Speicherkapazität kennzeichnenden Verschleißgröße als Funktion der ermittelten umgesetzten Ladungsmenge erfolgt. Dabei wird ausgenutzt, dass der Ladevorgang die den Verschleiß des Energiespeichers hervorrufenden strukturellen Veränderungen in den elektrochemisch aktiven Materialien maßgeblich bestimmt und zudem die verschleißträchtigen Überladungen berücksichtigt werden. Durch die fortlaufende Ermittlung der umgesetzten Ladungsmengen wird ausgenutzt, dass der Verlust an Speicherfähigkeit progressiv mit zunehmender Menge an umgesetzter Ladung während der Ladezyklen zunimmt und die Entladezyklen auf diesen Verlust keinen wesentlichen Einfluss haben.

Es sind auch Verfahren zur Batteriezustandsermittlung beispielsweise aus der DE 195 40 827 C2 bekannt, bei denen batteriespezifische Kennfelder der Batteriealterung genutzt werden, um aus erfassten Momentanwerten der Batteriealterungseinflussgrößen mit Hilfe des Kennfeldes einen Batteriealterungswert zu ermitteln.

Beispielsweise in der DE 103 35 928 A1 ist ein Verfahren zur Ermittlung einer auf den Ladezustand einer speicherbatteriebezogenen Kenngröße beschrieben, bei dem ein erster auf die Ruhespannung der Batterie bezogener Ladezustandswert und ein zweiter auf die umgesetzte Ladungsmenge bezogener Ladezustandswert bestimmt wird. Die beiden Ladezustandswerte werden hinsichtlich ihrer Ladezustandsänderung ausgewertet, um aus den beiden Ladezustandsänderungen eine Kenngröße für den Batteriezustand abzuleiten.

DE 102 317 00 A1 beschreibt ein Verfahren zur Ermittlung der einer Batterie noch entnehmbaren Ladungsmenge durch Messung der Batteriestrom- und spannungswerte zu mindestens zwei Zeitpunkten vor und während einer Anstiegsphase und während oder nach einer Abklingphase eines Lade- oder Entladevorgangs.

Diese und andere Verfahren zur Batteriezustandsermittlung werden in Fahrzeugen eingesetzt, um sicherzustellen, dass die Batterie aktuell und zukünftig ihre Aufgaben erfüllt. Auf der Information der Batteriezustandserkennung werden vielfältige weitere Funktionen aufgebaut, die für den Fahrer des Fahrzeugs spürbare Auswirkungen haben. Zum Beispiel werden Verbraucher, wie Sitzheizung, abgeschaltet, wenn ein schwacher Ladezustand SOC und/oder ein bestimmter Alterungszustand SOH von der Batteriezustandserkennung festgestellt wird. Daher kommt der Genauigkeit und der Stabilität der Ergebnisse der Batteriezustandserkennung eine wichtige Rolle zu. Die Genauigkeit der Batteriezustandserkennung kann durch entsprechende Algorithmen und Messtechnik gewährleistet werden. Die Stabilität der Ergebnisse muss aber gesondert überwacht werden. Ausgabegrößen der Batteriezustandserkennung, wie z. B. der Alterungszustand SOH oder der Kapazitätsverlust Qv, beruhen auf verschiedenen Eingangsgrößen, wie beispielsweise dem Batterieklemmenstrom, der Batterieklemmenspannung, der Temperatur und internen Zustandsgrößen, wie z. B. der Innenwiderstand, der Batterietemperatur aus einem Batterietemperaturmodell, etc.. Tritt aus irgendeinem Grund ein größerer Fehler in einer der Messgrößen, Eingangsgrößen oder Zustandsgrößen auf, hat das unmittelbare Auswirkungen auf die Ausgangsgrößen. Weiterhin kann es aber auch häufig notwendig sein, schnelle Änderungen im Batteriezustand als solche zu erkennen. So kann z. B. die Erkennung einer schnellen Zunahme des Kapazitätsverlustes wichtig sein. Hier muss dann unterschieden werden zwischen einer wirklichen Änderung in der Batterie und einer normalen Streuung bzw. Ausreißern der Mess-, Eingangs- oder Zustandsgrößen.

Aufgabe der Erfindung ist es daher, ein verbessertes Verfahren zur Batteriezustandsermittlung zu schaffen.

Die Aufgabe wird mit dem Verfahren zur Batteriezustandsermittlung gelöst durch statistisches Bewerten mindestens einer ermittelten Kenngröße für den Batteriezustand mittels einer statistischen Prozesskontrolle.

Wesentliche Methoden der statistischen Prozesskontrolle sind Qualtiätsregelkarten (Quality Control Charts). Das prinzipielle Vorgehen wird beispielsweise in www.statsoft.ccm/textbook/stquacon.html wie folgt beschrieben:

Die allgemeine Vorgehensweise zur Online-Qualitätskontrolle ist geradeaus gerichtet: Es werden einfach Werte einer bestimmten Größe aus dem laufenden Produktionsprozess extrahiert. Dann werden Liniendiagramme der Veränderlichkeit dieser Werte erzeugt und ihre Nähe zu Zielvorgaben bestimmt. Wenn sich ein Trend in diesen Linien herausstellt oder wenn Werte aus vorgegebenen Grenzen herausfallen wird der Prozess als außer Kontrolle geraten erklärt und es werden Maßnahmen zum Auffinden der Ursache des Problems ergriffen. Diese Typen von Diagrammen werden manchmal auch als Shewhart Regelkarten (benannt nach W. A. Shewhart, der generell als der erste angesehen wird, der diese Methoden eingeführt hat) bezeichnet.

Durch die Anwendung von Verfahren der statistischen Prozesskontrolle auf die Ausgabengrößen der Batteriezustandserkennung ist es auf einfache und zuverlässige Weise möglich, Ausreißer der Kenngrößen zu entdecken und starke Änderungen im Trend der Ausgabe-Kenngrößen zu detektieren.

Verfahren der statistischen Prozesskontrolle sind beispielsweise in Douglas C. Montgomery: Introduction to Statistical Quality Control, 5th ed., International edition, Hoboken NJ. Wiley 2005 beschrieben. Die Verfahren zur statistischen Prozesskontrolle wurden bislang insbesondere zur Qualitätskontrolle in Produktionsprozessen eingesetzt.

Mit dem Verfahren die Erkenntnis ausgenutzt, dass sich die Verfahren zur statistischen Prozesskontrolle auch auf die Ergebnisse von Batteriezustandserkennungsalgorithmen angewendet werden können, obwohl abgeleitete Größen und keine Messgrößen bewertet werden und auch keine stationären Prozesse vorliegen. Die Batteriezustandserfassung wird dabei als ein Prozess betrachtet, der statistisch analysiert werden kann.

Die Kenngröße einer Batterie kann nicht nur die Zustandsgröße einer Batterie sein, wie Ladezustand, Temperatur, Kapazitätsverlust, sondern auch eine Änderungsrate einer der Zustandsgrößen umfassen, da diese eine wichtige Größe zur Charakterisierung einer Batterie darstellen kann, z.B. die Änderungsrate des Kapazitätsverlustes.

Das statistische Bewerten der mindestens einen Kenngröße erfolgt vorzugsweise durch

- Festlegen eines Beobachtungsfensters für die mindestens eine Kenngröße, innerhalb dessen die mindestens eine Kenngröße als stationär angenommen wird, und

- Erkennen einer schnellen Änderung einer ermittelten Kenngröße, wenn die mindestens eine Kenngröße definierte Kontrollgrenzen überschreitet und die Streuung der Kenngröße eine definierte Streugrenze nicht überschreitet.

Alternativ oder zusätzlich hierzu kann das statistische Bewerten der mindestens einen Kenngröße auch ein:

- Festlegen eines Beobachtungsfensters für die mindestens eine Kenngröße, innerhalb dessen die mindestens eine Kenngröße als stationär angenommen wird, und
- Erkennen eines nicht durch die Batterie verursachten unplausiblen Wertes für eine ermittelte Kenngröße, wenn die Streuung der Kenngrößen eine definierte Streugrenze überschreitet,

beinhalten.

Durch das Beobachtungsfenster wird berücksichtigt, dass sich der Zustand einer Batterie kontinuierlich ändert. Das Beobachtungsfenster ist vorzugsweise ein Zeitfenster, das z.B. von der Dynamik der Kenngröße abhängig gewählt werden kann. Das Beobachtungsfenster kann aber auch ein Ereigniszahlfenster mit einer Anzahl an betrachteten aufeinander folgend ermittelten Werten für die Kenngröße sein. Bei der statistischen Bewertung werden dann nur Werte der mindestens einen Kenngröße berücksichtigt, die in dem Beobachtungsfenster liegen.

Ein unplausibler Wert einer ermittelten Kenngröße kann zudem beispielsweise angenommen werden, wenn der Absolutwert der mittleren Streuung größer als ein definierter Streugrenzwert ist.

Eine Kenngröße kann beispielsweise der Kapazitätsverlust eines Akkumulators, insbesondere einer Blei-Säure-Batterie eines Kraftfahrzeuges sein.

Die statistische Bewertung kann mit aus der statistischen Prozesskontrolle bekannten Verfahren, wie beispielsweise einer Qualitätsregelkarte (I&MR-Chart) oder ähnliches sein und insbesondere rechnergestützt durchgeführt werden.

Aufgabe der Erfindung ist es weiterhin, eine verbesserte Einrichtung zur Batteriezustandserkennung zu schaffen.

Die Aufgabe wird mit der Einrichtung der eingangs genannten Art gelöst durch eine Bewertungseinheit, die zur statistischen Bewertung der mindestens einen ermittelten Kenngröße mittels einer statistischen Prozesskontrolle mit dem oben beschriebenen Verfahren eingerichtet ist. Die Bewertungseinheit ist vorzugsweise ein mit einem geeigneten Programm versehener Mikrocontroller oder Mikroprozessor. Als Mikroprozessor kann beispielsweise ein zentraler Prozessor genutzt werden, der auch für die Steuerung des Motormanagements zuständig ist.

Die Erfindung wird nachfolgend anhand der beigefügten Zeichnungen beispielhaft näher erläutert. Es zeigen:

Fig. 1 - Flussdiagramm einer Ausführungsform des Verfahrens zur Batteriezustandsermittlung mit statistischer Bewertung der ermittelten Kenngrößen;

Fig. 2 - Diagramm des Kapazitätsverlustes mit unteren und oberen Grenzwerten über eine Anzahl an Ereigniszahlen;

Fig. 3 - Diagramm einer Streugröße der mittleren Streuung und einer oberen Kontrollgrenze für die Streuung über eine Anzahl von Ereigniszahlen;

Fig. 4 - Diagramm eines weiteren Beispiels des Kapazitätsverlustes mit oberer und unterer Kontrollgrenze über eine Anzahl an Ereigniszahlen;

Fig. 5 - Diagramm der Streugröße, der mittleren Streuung und einer oberen Kontrollgrenze für die Streuung über eine Anzahl von Ereigniszahlen für das Beispiel aus Fig. 4;

Fig. 6 - Diagramm eines weiteren Beispiels des Kapazitätsverlustes mit oberer und unterer Kontrollgrenze über eine Anzahl an Ereigniszahlen;

Fig.7 - Diagramm der Streugröße, der mittleren Streuung und einer oberen Kontrollgrenze für die Streuung über die Anzahl von Ereigniszahlen für das Beispiel aus Figur 6.

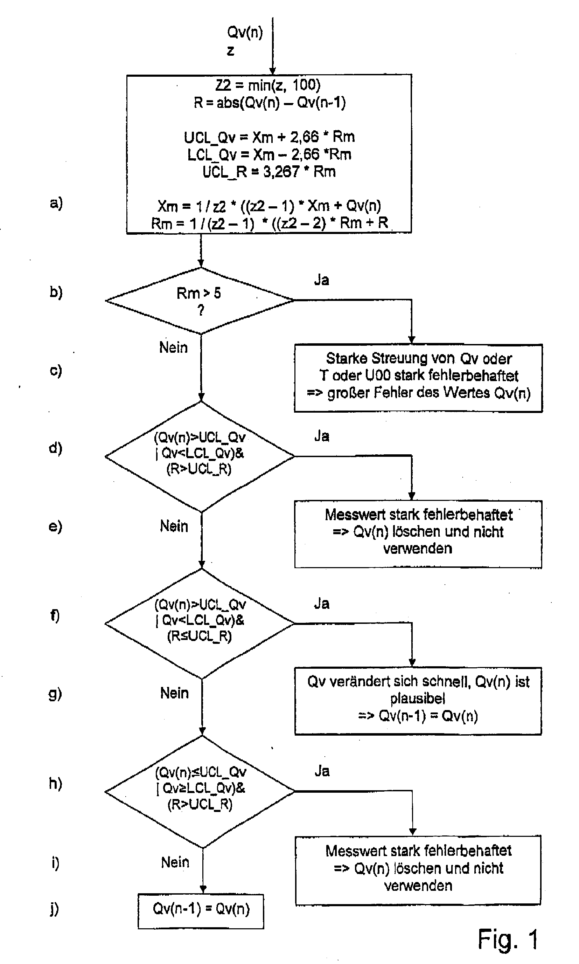

Figur 1 lässt ein Flussdiagramm eines Ausführungsbeispiels für das Verfahren zur Batteriezustandsermittlung mit statistischer Bewertung mindestens einer ermittelten Kenngröße (Z) für den Batteriezustand mittels einer statistischen Prozesskontrolle erkennen.

In dem Beispiel ist die Ausgangsgröße eines an sich bekannten Batteriezustandserkennungsverfahrens der Kapazitätsverlust $Qv$ (n) pro Zeitpunkt bzw. Ereigniszahl n. Der Kapazitätsverlust $Qv$ (n) hat die Einheit Prozent. Weiterhin ist die Zahl z der gültigen Ausgaben von Werten für den Kapazitätsverlust $Qv$ bekannt.

Da die Algorithmen zur Ermittlung der Kenngröße $Qv$ aus dem Stand der Technik, z.B. aus der DE 102 317 00 A1 hinreichend bekannt sind und für das weitere Verfahren der konkrete Algorithmus, mit dem der Kapazitätsverlust $Qv$ bestimmt wird, keine Rolle spielt, wird hierauf nicht näher eingegangen. Vielmehr ist zu verstehen, dass das nachfolgend beschriebene Verfahren auf nahezu jedem beliebigen Algorithmus zur Batteriezustandserkennung aufgesetzt und in Kombination mit diesem eingesetzt werden kann.

Auf die Ausgangsgröße, z.B. den Kapazitätsverlust $Qv$, des Batteriezustandserkennungsalgorithmus werden die aus der statistischen Prozesskontrolle bekannten Verfahren angewendet, wie beispielsweise ein I&MR-Chart.

In einem ersten Schritt a) werden Werte für den Mittelwert $Xm$ für den Kapazitätsverlust $Qv$ und den Mittelwert $Rm$ der Streuung der Werte für den Kapazitätsverlust $Qv$ initialisiert. Es wird ein Beobachtungsfenster festgelegt, das ein festgelegter Zeitraum oder eine festgelegte Anzahl an Werten der Ausgangsgrößen erfassen kann. Da sich der Zustand der Batterie kontinuierlich ändert, muss das Beobachtungsfenster entsprechend klein gewählt werden. Die Größe des Beobachtungsfensters richtet sich nach der Dynamik der betrachteten Kenngröße z, d. h. im vorliegenden Beispiel nach der Dynamik des Kapazitätsverlustes $Qv$. In dem dargestellten Beispiel wird das Beobachtungsfenster für den Kapazitätsverlust $Qv$ auf 100 Werte beschränkt. Hierzu wird eine Zählvariable z2 nach der Gleichung

$$z2 = \min (z, 100)$$

definiert. Die gewählte Größe für das Beobachtungsfenster von 100 Werten entspricht bei angenommenen zwei Motorstarts pro Tag etwa 50 Tagen. Das ist plausibel, da üblicherweise die Änderung des Kapazitätsverlustes $Qv$ in 50 Tagen deutlich kleiner ist als die Streuung R.

Die Streuungsgröße für die Kenngröße Z berechnet sich beispielsweise nach der Formel:

$$R = abs \ (Qv(n) - Qv(n-1)),$$

wobei Q(n-1) der vorhergehende Wert des Kapazitätsverlustes $Qv$ vor dem aktuellen Wert $Qv$(n) ist.

Die Berechnung der Mittelwerte $Xm$ und $Rm$ ist in der Praxis problematisch, da zu viele Werte gespeichert bleiben müssen. In dem dargestellten Beispiel wird daher eine Art Tiefpassfilter zur Mittelwertberechnung verwendet. Der neue Mittelwert $Xm$(n) für den Kapazitätsverlust $Qv$ berechnet sich dann nach der Formel:

$$Xm(n) = 1/(z2-1) \cdot ((z2-2) \cdot Xm(n-1) + Qv(n)),$$

wobei $Xm$(n-1) der vorhergehend berechnete (alte) Wert für den Mittelwert des Kapazitätsverlustes ist.

Der neue Mittelwert für die Streugröße R, d. h. die mittlere Streuung $Rm$(n), berechnet sich nach der Formel:

$$Rm(n) = 1/z2 \cdot ((z2-1) \cdot Rm(n-1) + R),$$

wobei $Rm(n-1)$ der vorhergehend berechnete (alte) Wert für die mittlere Streuung ist.

Die Berechnung der Mittelwerte Xm und Rm erfolgt nach Abfrage von oberen und unteren Kontrollgrenzen UCL_Qv, LCL_Qv und UCL_R.

Die obere Kontrollgrenze UCL_Qv für den aktuellen Kapazitätsverlust $Qv(n)$ wird beispielsweise nach der Formel

$$UCL\_Qv = Xm(n) + 2,66 \cdot Rm(n)$$

berechnet. Die untere Kontrollgröße LCL_Qv für den aktuellen Kapazitätsverlust $Qv(n)$ wird beispielsweise nach der Formel

$$LCL\_Qv = Xm(n) - 2,66 \cdot Rm(n)$$

berechnet. Die obere Kontrollgrenze für die Streugröße R berechnet sich beispielsweise nach der Formel:

$$UCL\_R = 3,267 \cdot Rm(n).$$

In einem Schritt b) wird überprüft, ob der Mittelwert der Streuung Rm eine definierte Streugrenze von beispielsweise fünf überschreitet. Wenn dies der Fall ist, wird im Schritt c) festgestellt, dass die Messungen stark streuen oder die Eingangsgrößen des Algorithmus zur Bestimmung des Kapazitätsverlustes Qv, insbesondere die Temperatur oder die Ruhespannung $U_{00}$, stark fehlerbehaftet sind. Damit wird erkannt, dass ein großer Fehler des aktuellen Wertes für den Kapazitätsverlust Qv vorliegt. Dieser spezielle Einzelwert $Qv(n)$ kann dann einfach für die nachfolgende Fahrzeug- oder Batteriesteuerung ignoriert werden.

Für den Fall, dass die mittlere Streuung Rm den definierten Streugrenzwert von z.B. fünf nicht überschreitet, wird im Schritt d) überprüft, ob der aktuelle Wert für den Kapazitätsverlust $Qv(n)$ größer als der obere Grenzwert UCL_Qv für den Kapazitätsverlust Qv oder kleiner als der untere Grenzwert LCL_Qv für den Kapazitätsverlust Qv ist und gleichzeitig die Streuung R größer als die obere Kontrollgrenze UCL_R für die Streuung R ist. Wenn dies der Fall ist, wird der aktuelle Wert des Kapazitätsverlustes $Qv(n)$ gelöscht und nicht weiter verwendet, da der Einzelwert $Qv(n)$ stark fehlerbehaftet ist (Schritt e)).

Andernfalls wird in einem Schritt f) überprüft, ob der aktuelle Wert $Qv(n)$ größer als der obere Grenzwert UCL_Qv oder kleiner als der untere Grenzwert LCL_Qv für den Kapazitätsverlust Qv ist und gleichzeitig die Streuung R kleiner oder gleich dem oberen Grenzwert UCL_R für die Streuung ist. Wenn dies der Fall ist, wird in einem Schritt g) festgestellt, dass sich der Wert des Kapazitätsverlustes Qv schnell verändert, aber plausibel ist. Zur Vorbereitung des nächsten Iterationsschritts wird der momentan aktuelle Wert für den Kapazitätsverlust $Qv(n)$ als im nächsten Iterationsschritt alter Wert für den Kapazitätsverlust $Qv(n-1)$ gesetzt (Schritt g).

Andernfalls wird in einem Schritt h) überprüft, ob der aktuelle Wert für den Kapazitätsverlust $Qv(n)$ kleiner oder gleich dem oberen Grenzwert UCL_Qv und größer oder gleich dem unteren Grenzwert LCL_Qv für den Kapazitätsverlust Qv ist und die Streuung R größer als der obere Grenzwert für die Streuung R ist. Es wird also untersucht, ob sich der Wert für den Kapazitätsverlust Qv innerhalb der oberen und unteren Grenzwerte befindet und nur die Streuung R die definierte Streugrenze UCL_R überschreitet. Wenn dies der Fall ist, wird in einem Schritt i) erkannt, dass der Messwert eventuell stark streut, aber keine weitere Aktion erforderlich ist. Dieser spezielle Einzelwert $Qv(n)$ kann dann einfach für die nachfolgende Fahrzeug- oder Batteriesteuerung ignoriert werden.

Andernfalls wird in einem j) lediglich zur Vorbereitung des nächsten Iterationsschritts der momentan aktuelle Wert für den Kapazitätsverlust $Qv(n)$ als im nächsten Iterationsschritt alter Wert für den Kapazitätsverlust $Qv(n-1)$ gesetzt und der momentan aktuelle Wert für den Kapazitätsverlust $Qv(n)$ für die weitere Steuerung der Batterie oder des Fahrzeuges genutzt.

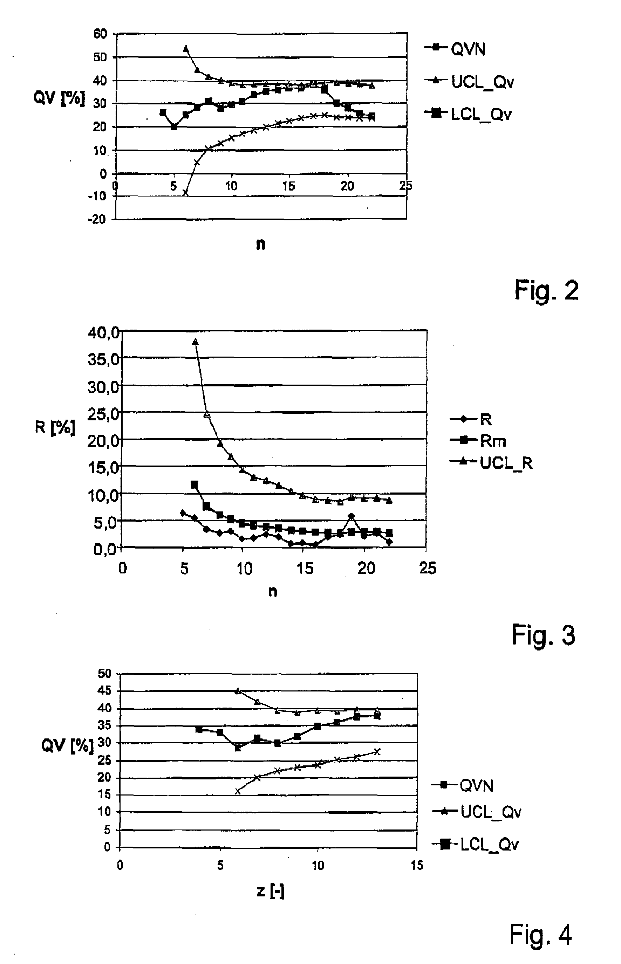

Die Figuren 2 und 3 lassen Diagramme des Kapazitätsverlustes Qv und der Streuung R in Prozent über eine Anzahl n von Ereigniszahlen in Verbindung mit dem oberen Grenzwert UCL_Qv und dem unteren Grenzwert LCL_Qv und dem oberen Grenzwert UCL_R erkennen. Die in den Figuren 2 und 3 dargestellten Diagramme resultieren aus beispielhaften Anwendungen des Verfahrens zur Batteriezustandsermittlung. Es ist deutlich, dass sich die ermittelten Werte für den Kapazitätsverlust Qv (n) innerhalb der definierten Grenzen bewegen. Das bedeutet, dass die Ergebnisse stabil sind. Ausreißer der Mess-, Eingangs- oder Zustandsgrößen oder starke Trends werden nicht entdeckt.

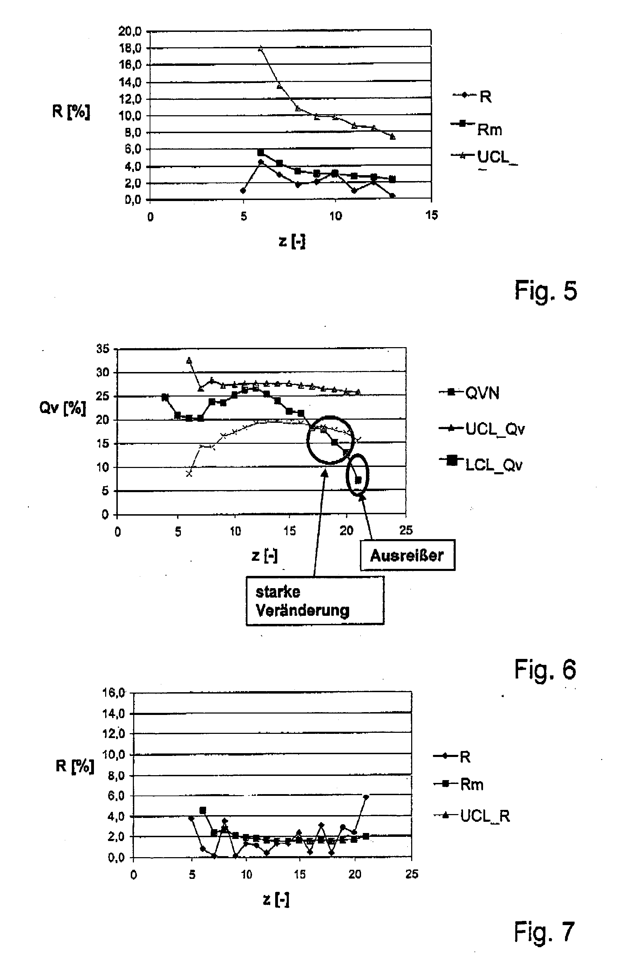

Die Figuren 4 und 5 lassen wiederum Diagramme des Kapazitätsverlustes Qv und der Streuung R über eine Anzahl n von Ereigniszahlen mit den oberen und unteren Grenzwerten UCL_Qv, LCL_Qv und UCL_R erkennen. Auch bei diesem Beispiel bewegen sich die ermittelten Werte Qv (n) innerhalb der definierten Grenzen. Die Ergebnisse sind ebenfalls stabil und es werden auch keine Ausreißer oder starken Trends entdeckt.

Die Figuren 6 und 7 lassen ein weiteres Beispiel in Form eines Diagrammes des Kapazitätsverlustes Qv und der Streuung R über eine Anzahl n von Ereigniszahlen erkennen. Es wird deutlich, dass etwa bei einer Ereigniszahl von 17 der aktuelle Wert für den Kapazitätsverlust Qv (n) den unteren Grenzwert LCL_Qv für den Kapazitätsverlust Qv (n) unterschreitet. Hieraus wird eine starke Veränderung des Kapazitätsverlustes Qv geschlossen. Die ermittelten Werte für den Kapazitätsverlust Qv (n) sind dennoch plausibel. Bei dem letzten Messwert für den Kapazitätsverlust Qv (n) wird eine Überschreitung des oberen Grenzwertes UCL_R für die Streuung R festgestellt und hieraus erkannt, dass der Messwert für den Kapazitätsverlust Qv (n) aufgrund der Überschreitung unplausibel ist und es sich bei dem letzten Messwert um einen Ausreißer handelt, der für das weitere Verfahren ignoriert wird.

## Patentansprüche

1. Verfahren zur Batteriezustandsermittlung, **gekennzeichnet durch** statistisches Bewerten mindestens einer ermittelten Kenngröße (Z) für den Batteriezustand mittels einer statistischen Prozesskontrolle.

2. Verfahren nach Anspruch 1, **gekennzeichnet durch** Erkennen eines unplausiblen Wertes für eine ermittelte Kenngröße (Z), wenn der Absolutwert der mittleren Streuung (Rm) größer als ein definierter Streugrenzwert ist.

3. Verfahren nach Anspruch 1 oder 2, **dadurch gekennzeichnet, dass** das statistische Bewerten der mindestens einen Kenngröße (Z) erfolgt durch

   - Festlegen eines Beobachtungsfensters für die mindestens eine Kenngröße (Z), innerhalb dessen die mindestens eine Kenngröße (Z) als stationär angenommen wird, und
   - Erkennen einer schnellen Veränderung einer ermittelten Kenngröße (Z), wenn die mindestens eine Kenngröße (Z) definierte Kontrollgrenzen (UCL_QV, LCL_QV) überschreitet und die Streuung (R) der Kenngröße (Z) eine definierte Streugrenze (UCL_R) nicht überschreitet.

4. Verfahren nach einem der Ansprüche 1 bis 3, **dadurch gekennzeichnet, dass** das statistische Bewerten der mindestens einen Kenngröße (Z) erfolgt durch

   - Festlegen eines Beobachtungsfensters für die mindestens eine Kenngröße (Z), innerhalb dessen die mindestens eine Kenngröße (Z) als stationär angenommen wird, und
   - Erkennen eines nicht durch die Batterie verursachten unplausiblen Wertes für eine ermittelte Kenngröße (Z), wenn die Streuung (R) der Kenngrößen (Z) eine definierte Streugrenze (UCL_R) überschreitet.

5. Verfahren nach einem der vorhergehenden Ansprüche, **dadurch gekennzeichnet, dass** das Beobachtungsfenster ein Zeitfenster ist.

6. Verfahren nach Anspruch 5, **dadurch gekennzeichnet, dass** das Beobachtungsfenster von der Dynamik der Kenngröße (Z) abhängig gewählt wird.

7. Verfahren nach einem der Ansprüche 1 bis 4, **dadurch gekennzeichnet, dass** das Beobachtungsfenster eine Anzahl an betrachteten, aufeinanderfolgend ermittelten Werten für die Kenngröße (Z) ist.

8. Verfahren nach einem der vorhergehenden Ansprüche, **dadurch gekennzeichnet, dass** bei der statistischen Bewertung nur Werte der mindestens einen Kenngröße (Z) berücksichtigt werden, die in dem Beobachtungsfenster liegen.

9. Verfahren nach einem der vorhergehenden Ansprüche, **dadurch gekennzeichnet, dass** eine Kenngröße (Z) der Kapazitätsverlust (Qv) eines Akkumulators ist.

10. Verfahren nach einem der vorhergehenden Ansprüche, **dadurch gekennzeichnet, dass** die mittlere Streuung (Rm) und/oder ein Mittelwert (Xm) für die Kenngröße (Z) mittels Filterung berechnet wird.

11. Verfahren nach einem der vorhergehenden Ansprüche, **dadurch gekennzeichnet, dass** das statistische Bewerten mit Hilfe mindestens eines Typs einer Qualitätsregelkarte erfolgt.

12. Verfahren nach einem der vorhergehenden Ansprüche, **dadurch gekennzeichnet, dass** mehrere Kenngrößen (Z) gleichzeitig ermittelt und statistisch bewertet werden und die mehreren Kenngrößen (Z) miteinander kombiniert werden, um einen Batteriezustand abzuleiten.

13. Einrichtung zur Batteriezustandserkennung mit einer Messeinheit für die Batterieklemmenspannung und/oder den Batterieklemmenstrom und mit einer Einheit zur Ermittlung mindestens einer Kenngröße (Z) für den Batteriezustand aus der gemessenen Batterieklemmenspannung und/oder dem gemessenen Batteriestrom, **gekennzeichnet durch** eine Bewertungseinheit, die zur statistischen Bewertung der mindestens einen ermittelten Kenngröße (Z) zumindest mittels einer statistischen Prozesskontrolle mit dem Verfahren nach einem der vorhergehenden Ansprüche eingerichtet ist.

Fig. 1

Fig. 2

Fig. 3

Fig. 4

Fig. 5

**Ausreißer**

**starke Veränderung**

Fig. 6

Fig. 7

Europäisches
Patentamt

**EUROPÄISCHER RECHERCHENBERICHT**

Nummer der Anmeldung

EP 07 01 7561

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | DE 199 59 019 A1 (BOSCH GMBH ROBERT [DE]) 13. Juni 2001 (2001-06-13) * das ganze Dokument * ----- | 1,3-8, 10-13 | INV. G01R31/36 |
| X | US 2004/128089 A1 (BARSOUKOV EVGENIJ [US] ET AL) 1. Juli 2004 (2004-07-01) * Absatz [0053] - Absatz [0055]; Abbildung 4 * ----- | 1,5,7,8, 10-13 | |
| X | JP 2002 063944 A (HITACHI MAXELL) 28. Februar 2002 (2002-02-28) * Zusammenfassung; Abbildung 13 * ----- | 1,2,9 | |
| X | DE 40 14 737 A1 (FRAUNHOFER GES FORSCHUNG [DE]) 15. November 1990 (1990-11-15) * das ganze Dokument * ----- | 1,13 | |
| X | US 5 789 923 A (SHIMOYAMA KENICHI [JP] ET AL) 4. August 1998 (1998-08-04) * Abbildung 5 * ----- | 1,13 | |
| X | EP 1 094 326 A (VB AUTOBATTERIE GMBH [DE] VB AUTOBATTERIE GMBH & CO KGAA [DE]) 25. April 2001 (2001-04-25) * Absatz [0020] * ----- | 1,13 | RECHERCHIERTE SACHGEBIETE (IPC) G01R |
| X | US 5 349 540 A (BIRKLE MICHAEL [DE] ET AL) 20. September 1994 (1994-09-20) * Ansprüche 1,5,12,14 * ----- | 1,13 | |
| A | US 2003/115232 A1 (LIPP JOHN [US] LIPP JOHN I [US]) 19. Juni 2003 (2003-06-19) * Zusammenfassung * ----- | 3,4 | |

Der vorliegende Recherchenbericht wurde für alle Patentansprüche erstellt

| Recherchenort | Abschlußdatum der Recherche | Prüfer |
|---|---|---|
| Den Haag | 10. Januar 2008 | Koll, Hermann |

KATEGORIE DER GENANNTEN DOKUMENTE

X : von besonderer Bedeutung allein betrachtet
Y : von besonderer Bedeutung in Verbindung mit einer
anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
nach dem Anmeldedatum veröffentlicht worden ist
D : in der Anmeldung angeführtes Dokument
L : aus anderen Gründen angeführtes Dokument
........................................................................
& : Mitglied der gleichen Patentfamilie, übereinstimmendes
Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 07 01 7561

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

10-01-2008

| Im Recherchenbericht angeführtes Patentdokument | | Datum der Veröffentlichung | Mitglied(er) der Patentfamilie | | Datum der Veröffentlichung |
|---|---|---|---|---|---|
| DE 19959019 | A1 | 13-06-2001 | WO<br>EP<br>ES<br>JP<br>US | 0142799 A1<br>1163532 A1<br>2240226 T3<br>2003516618 T<br>6668233 B1 | 14-06-2001<br>19-12-2001<br>16-10-2005<br>13-05-2003<br>23-12-2003 |
| US 2004128089 | A1 | 01-07-2004 | KEINE | | |
| JP 2002063944 | A | 28-02-2002 | KEINE | | |
| DE 4014737 | A1 | 15-11-1990 | KEINE | | |
| US 5789923 | A | 04-08-1998 | JP<br>JP | 3079022 B2<br>9127215 A | 21-08-2000<br>16-05-1997 |
| EP 1094326 | A | 25-04-2001 | DE<br>ES | 19950424 A1<br>2281320 T3 | 26-04-2001<br>01-10-2007 |
| US 5349540 | A | 20-09-1994 | KEINE | | |
| US 2003115232 | A1 | 19-06-2003 | KEINE | | |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1353190 A1
- DE 19540827 C2
- DE 10335928 A1
- DE 10231700 A1

**In der Beschreibung aufgeführte Nicht-Patentliteratur**

- **DOUGLAS C. MONTGOMERY.** Introduction to Statistical Quality Control. Wiley, 2005